# EUROPEAN PATENT APPLICATION

(11) **EP 2 383 812 A1**
(43) Date of publication of application: **02.11.2011**
(21) Application number: 09834781.8
(22) Date of filing: 18.12.2009
(51) Int. Cl.: H01L 51/42

(54) **PHOTOVOLTAIC DEVICE**

(30) Priority: 24.12.2008 JP 2008326803
(71) Applicant: Hitachi, Ltd., Chiyoda-ku Tokyo 100-8280 (JP)
(72) Inventor: NAITO Hiroto, Hiki-gun Saitama 350-0395 (JP); YOSHIMOTO Naoki, Hiki-gun Saitama 350-0395 (JP)
(74) Representative: MERH-IP Matias Erny Reichl Hoffmann
(86) International application number: PCT/JP2009/071112
(87) International publication number: WO 2010/073980

(57) **Abstract**

Disclosed is a photoelectric conversion device including a transparent conductor layer formed on a light transmissive substrate, an electron blocking layer covering the surface of the transparent conductor layer, a bulk heterojunction type photoelectric conversion layer in contact with the electron blocking layer, a hole blocking layer covering the surface of the photoelectric conversion layer, and a counter electrode covering the hole blocking layer, wherein the hole blocking layer is made of a material having a band gap of 3.0 eV or more, thereby the migration of holes from the photoelectric conversion layer is prevented and recombination or leakage current is suppressed.

## Description

### TECHNICAL FIELD

The present invention relates to an organic thin film photoelectric conversion device structure having an oxide film of electrode material as a hole blocking layer.

### BACKGROUND ART

As a p-n junction structure of an organic thin film solar cell, there are included a bilayer p-n junction type in which a p-type organic semiconductor thin film and an n-type organic semiconductor thin film are stacked, an alternate adsorption photoelectric conversion layer type in which a p-n interface state can be controlled in a level of several nanometers, a bulk heterojunction type which forms a thin film comprising a p-type organic semiconductor material (acceptor) and an n-type organic semiconductor (donor) in a mixed state, and the like.

Among these organic thin film solar cells, in a type in which a low molecular-weight organic semiconductor material is used, a solar cell having a dense and uniform film structure can prepared by means of a vacuum deposition method. In addition, in a type in which a totally solid polymer type organic semiconductor is used, a solar cell can be prepared by means of a coating method or the like. Either preparation method has an advantage that the solar cell can be produced at a low cost. However, the organic thin film solar cell has a problem that the cell is still low in its reliability and stability, and also in conversion efficiency, and the like.

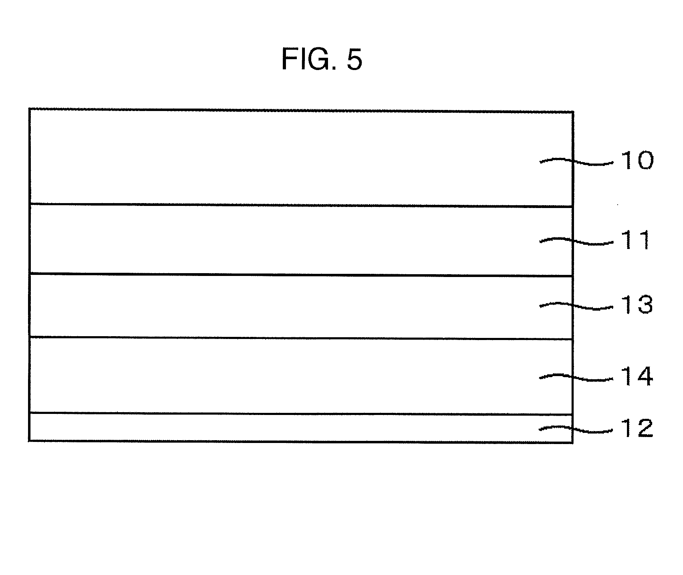

FIG 5 is a schematic diagram which illustrates a cross-sectional structure of the main parts of a conventional low-molecular-weight organic thin film solar cell. As represented in FIG 5, a transparent electrode 11 is formed adjacent to a transparent substrate 10 such as glass, a p-type semiconductor layer 13 (for example, Cu phthalocyanine (CuPc)) is formed adjacent to the transparent electrode 11, an n-type semiconductor layer 14 (for example, perylene derivative (PTCB I)) is formed adjacent to the p-type semiconductor layer 13, and an electrode 12 such as Ag and the like is formed adjacent to the n-type semiconductor layer 14. Each layer can be formed by means of a vapor deposition or the like. In such structure, a built-in electric field is formed in the vicinity of the p-n junction interface between the p-type semiconductor layer 13 and the n-type semiconductor layer 14. When excitons generated in the p-type semiconductor layer 13 of CuPc by photoexcitation migrate to the vicinity of the p-n junction interface, charge separation occurs by the built-in electric field, and the excitons are separated into electrons and positive holes as carriers, which are each transported to opposite electrodes 11 and 12, respectively, to generate power.

The problem here is that since the thickness of the layer has to be made thin because the excitons in the p-type semiconductor layer 13 can migrate only a short distance, and this causes shortage in the amounts of light absorption and the amounts of carriers to be generated, therefore high conversion efficiency cannot be obtained.

In addition, in organic thin films, a transportable distance of carriers is also short, and the limit is described to be generally about 100 nm. Therefore, even when the film thickness is made thicker to secure the amount of light absorption, there still remains such a problem that a possibility increases that the electrons and holes disappear by recombination before the carriers reach the electrodes 11 and 12, and as a result, the conversion efficiency cannot be improved.

Roughly, two ways can be thought to solve these problems. One way is to develop a novel organic semiconductor material having superior properties in the organic semiconductor material, such as improved mobility, carrier life, light absorption rate, and the like. However, it is forecasted that this way requires a large amount of research and development period and cost. Another way is that a high conversion efficiency is realized by a structural contrivance while existing organic semiconductor material is used. As a technique to realize this, there is a method in which an apparent effective area of the photoelectric conversion layer is increased.

As a specific example of the technique, the aforementioned bulk heterojunction type organic thin film solar cell has been known. The bulk heterojunction is a structure in which p-type semiconductor molecules or p-type semiconductor polymers and n-type semiconductor molecules are present in a mixed state in a layer to form p-n junctions at molecular level (in molecular size). As for the junction interface structure, formation of the p-n junctions in steric (three-dimensional) structure at the molecular level instead of the bilayer planar (two-dimensional) structure increases the junction interface and contributes to the realization of improvement in photo-currents.

As for the bulk heterojunction type organic thin film solar cell, there are two types of polymer type and low molecular-weight type. The former is a thin film in which the p-type and n-type semiconductors coexist, which is formed by dissolving a p-type organic semiconductor material (acceptor) and an n-type organic semiconductor material (donor) in a solvent, blending them in a solution state, and coating by a coating method, and the latter is one in which a thin film is formed by a co-deposition method in which the p-type semiconductor and the n-type semiconductor are simultaneously deposited using a vacuum deposition equipment.

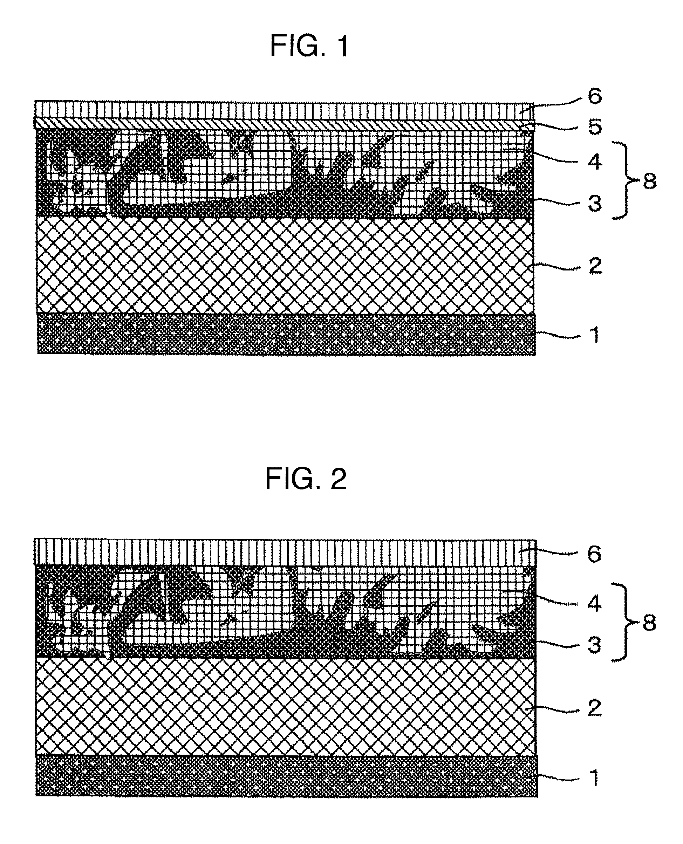

FIG 2 illustrates a cross-sectional drawing of a conventional bulk heterojunction type organic thin film solar cell. As illustrated in FIG 2, an electron blocking layer 2 is formed adjacent to a transparent conductor film 1, a photoelectric conversion layer 8 is formed adjacent to the electron blocking layer 2, and a counter electrode 6 is formed adjacent to a photoelectric conversion layer 8. The photoelectric conversion layer 8 is configured with a hole transport layer 3 containing p-type semiconductor polymers or p-type semiconductor molecules and an electron transport layer 4 containing n-type semiconductor molecules in a mixed state. The structure in the layer of photoelectric conversion layer 8 is not uniform, having no regularity in every sample.

The organic thin film solar cell in FIG 2 has such a structure that the cell has the bulk heterojunction type photoelectric conversion layer 8, and a counter electrode 6 is provided on said photoelectric conversion layer 8. However, the counter electrode 6 has been installed as an electron collecting electrode, and direct junction with the p-type semiconductor molecules or the p-type semiconductor polymers is not preferable because it induces recombination and leakage current.

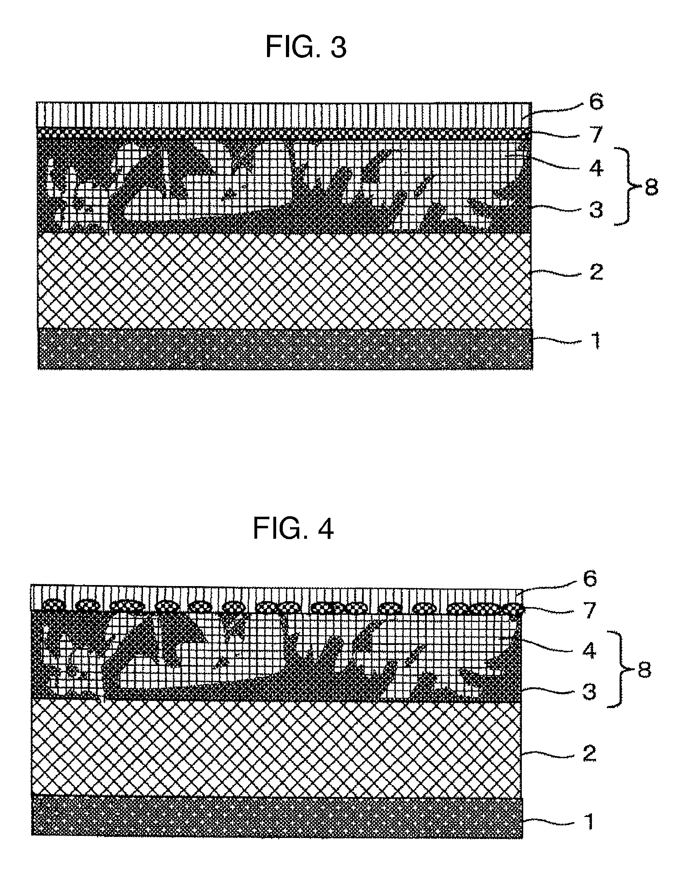

Therefore, a currently predominating structure is one illustrated in FIG 3. FIG 3 is a schematic diagram illustrating a cross-sectional structure of the main parts of the conventional bulk heterojunction type organic thin film solar cell in which a recombination preventing layer or a leakage current preventing layer has been inserted. In this structure, 1 is a transparent conductor film, 2 is an electron blocking layer, 3 is a hole transport layer containing the p-type semiconductor polymers or the p-type semiconductor molecules, 4 is an electron transport layer containing the n-type semiconductor molecules, 7 is an insulating substance layer or a dielectric layer, and 6 is a counter electrode. Similarly to the organic thin film solar cell illustrated in FIG 2, the photoelectric conversion layer 8 is configured with the hole transport layer 3 containing the p-type semiconductor polymers or the p-type semiconductor molecules and the electron transport layer 4 containing the n-type semiconductor molecules in a mixed state, and the layer configuration of the photoelectric conversion layer 8 is not uniform, having no regularity in every sample. A difference from the organic thin film solar cell of FIG 2 is a point that the insulating substance layer or dielectric substance layer 7 is deposited (stacked) on the bulk heterojunction type photoelectric conversion layer 8 in very thin of several nanometers at the maximum, and this point has an effect to prevent the recombination or the leakage current in the electrode by said insulating substance layer or dielectric substance layer 7 (see, for example, Patent Literature 1).

### CITATION LIST

### PATENT LITERATURES

PATENT LITERATURE 1: JP-A-2007-88033

### SUMMARY OF INVENTION

### TECHNICAL PROBLEM

However, the conventional hole blocking layer requires a separate step in which the insulating substance layer or the dielectric substance layer is deposited by several nanometers by means of the vapor deposition method, coating method, or the like. Further, when the thin film of several nanometers is deposited by these methods, the hole blocking layer becomes an island-like film as illustrated in FIG 4 instead of a layer structure, and there remains a problem in its denseness and uniformity of the film.

It is an object of the present invention to provide an organic photoelectric conversion device having a bulk heterojunction, wherein a dense and uniform hole blocking layer is provided between the bulk heterojunction layer and the counter electrode, and thereby the recombination of the charges and the leakage current can be suppressed.

### SOLUTION TO PROBLEM

In order to attain the above-described object, the present invention provides a photoelectric conversion device comprising a transparent conductor layer formed on a light transmissive substrate, an electron blocking layer covering the surface of said transparent conductor layer, a bulk heterojunction type photoelectric conversion layer in contact with said electron blocking layer, a hole blocking layer covering the surface of said photoelectric conversion layer, and a counter electrode covering said hole blocking layer, wherein the hole blocking layer is configured with a material having a band gap of 3.0 eV or more, thereby the migration of holes from the photoelectric conversion layer is prevented and the recombination or the leakage current is suppressed.

In addition, in order to attain the above-described object, in the present invention, the following improvements and alterations can be added to the organic thin film solar cell according to the above present invention.

An oxide film of the electrode material is set as the hole blocking layer.

The hole blocking layer should have energy levels exhibiting the following relationship with the bulk heterojunction type photoelectric conversion layer.

The valence band level of the hole blocking layer has an energy level in a deeper position by 0.3 eV or more based on the vacuum level than the valence band level of the p-type semiconductor polymers or the p-type semiconductor molecules which form the photoelectric conversion layer.

The conduction band level of the hole blocking layer containing the n-type semiconductor molecules has an energy level in a deeper position than the conduction band level of the n-type semiconductor molecules which forms the bulk heterojunction, and the difference is less than 0.5 eV

### ADVANTAGEOUS EFFECTS OF INVENTION

According to the present invention, the organic thin film photoelectric conversion device, in which the recombination of the charges and the leakage current are suppressed, can be provided.

### BRIEF DESCRIPTION OF DRAWINGS

[FIG 1]
   FIG 1 is a schematic diagram illustrating a cross-sectional structure of the main parts of the photoelectric conversion device according to an embodiment of the present invention.
[FIG 2]
   FIG. 2 is a schematic diagram illustrating a cross-sectional structure of the main parts of a conventional bulk heterojunction type organic thin film solar cell.
[FIG 3]
   FIG 3 is a schematic diagram illustrating a cross-sectional structure of the main parts of a conventional bulk heterojunction type organic thin film solar cell in which a recombination preventing layer or a leakage current preventing layer has been inserted.
[FIG 4]
   FIG 4 is a schematic diagram illustrating a cross-sectional structure of the main parts of a conventional bulk heterojunction type organic thin film solar cell in which an insulating substance layer or a dielectric substance layer has been deposited by means of vapor deposition or coating method as a hole blocking layer.
[FIG 5]
   FIG 5 is a diagram illustrating a layer configuration of a conventional low molecular type organic thin film solar cell.

### DESCRIPTION OF EMBODIMENTS

Hereinafter, embodiments of the present invention will be explained by referring to the drawings.

FIG 1 is a schematic diagram illustrating a cross-sectional structure of the main parts of the photoelectric conversion device according to an embodiment of the present invention.

As illustrated in FIG 1, the photoelectric conversion device of the present embodiment is configured with a transparent conductor film 1, an electron blocking layer 2, a hole transport layer 3 containing p-type semiconductor polymers or p-type semiconductor molecules, an electron transport layer 4 containing n-type semiconductor molecules, a hole blocking layer 5 containing an oxide film of a counter electrode, and the counter electrode 6. A photoelectric conversion layer 8 has a structure in which the hole transport layer 3 containing the p-type semiconductor polymers or the p-type semiconductor molecules and the electron transport layer 4 containing the n-type semiconductor molecules are present in a mixed state in one layer, and each molecules or polymers have a function to generate excitons by light absorption and to transport charges. The counter electrode 6 is formed on this bulk heterojunction type photoelectric conversion layer 8, and an oxide film of the counter electrode is configured for the interface of the counter electrode 6 in contact with the photoelectric conversion layer 8.

The transparent conductor film 1 is desirably formed on a visible-light transmissive substrate by deposition. The substrate is preferably one which has high thermal stability during production process and as low penetration as possible for moisture and oxygen. When the substrate does not require flexibility and may be rigid, an inorganic material such as yttria-stabilized zirconia (YSZ), glass, a metal plate such as zinc, aluminum, stainless steel, chromium, tin, nickel, iron, copper, or a ceramic plate may be used. When flexibility is required, there is included an organic material such as polyester such as polyethylene terephthalate, polybutylene phthalate, polyethylene naphthalate; polystyrene; polycarbonate; polyether sulfon; polyarylate; polyimide; polycycloolefin; norbornene resin, poly(chlorotrifluoroethylene). In addition, an opaque plastic substrate may be used. Among the above-described organic materials, polycarbonate and the like are preferably used, in particular from the viewpoint of thermal stability. In the case of organic materials, ones which are superior in dimensional stability, solvent resistance, electrically insulating property, and workability besides thermal resistance are preferable. By using a flexible substrate as described above, there are such advantages that weight saving can be realized to improve portability and that resistance to bending stress can be improved, in comparison with the case when glass, metal or ceramic substrate is used.

The transparent conductor film 1 is a visible-light transmissive conductor film which is deposited by a thin film forming technique such as sputter method, CVD method, sol-gel method, coating-pyrolysis process, and indium tin oxide (ITO), zinc oxide (ZnO), tin oxide (SnO₂) and the like can be employed but not limited thereto. Since these oxide semiconductor thin films are usually hydrophobic, an organic semiconductor layer such as the electron blocking layer 2 cannot be directly deposited thereon. For this reason, UV irradiation is applied to the transparent conductor film for a prescribed time to form hydrophilic groups on the surface of the transparent conductor film and make the surface in such a state that the organic semiconductor layer can be easily deposited thereon. It should be noted that, as a criterion for the hydrophilic group formation, the hydrophilic group should be formed so that when one drop of pure water is dropped on the surface of the transparent conductor film, the contact angle of the liquid to the surface of the transparent conductor film becomes 10 degree or less.

The electron blocking layer 2 can be formed on the transparent conductor film 1 by depositing a conductive polymer such as PEDOT/PSS (poly-(3,4-ethylenedioxythiophene) / polystyrenesulfonic acid) and the like by means of techniques such as the coating method, a spin-coat method, and then through a drying step and a vacuum firing step.

The photoelectric conversion layer 8 comprises the hole transport layer 3 containing the p-type semiconductor polymers or the p-type semiconductor molecules and the electron transport layer 4 containing the n-type semiconductor in a mixed state, and the layer structure is not uniform, having no regularity. A mixing ratio of the p-type semiconductor polymers or the p-type semiconductor molecules and the n-type semiconductor molecules is desirably 1 : 0.8 by weight but not limited thereto. After preparing a solution by dissolving the p-type semiconductor polymers or the p-type semiconductor molecules and the n-type semiconductor molecules in a solvent in a desired ratio, the solution is subjected to sufficient stirring such as ultrasonic agitation, and then the photoelectric conversion layer 8 is deposited by means of the technique such as the spin-coat method or the coating method. After that, the photoelectric conversion layer 8 is formed on the electron blocking layer 2 through the drying step and the vacuum firing step. It should be noted that, the thin film forming method is not limited thereto.

The organic p-type semiconductor or p-type semiconductor polymer is a donating organic semiconductor represented mainly by a hole transporting organic compound, and indicates an organic compound having an electron-donating property (electron-donating organic material). In more detail, when two kinds of organic materials are used in contact with each other, an organic compound having a lower ionization potential is the organic p-type semiconductor or p-type semiconductor polymer. Therefore, any organic compound can be used as a donating organic compound, so long as the organic compound has an electron-donating property. For example, a triarylamine compound, a benzidine compound, a pyrazoline compound, a styrylamine compound, a hydrazone compound, a triphenylmethane compound, a carbazole compound, a polysilane compound, a thiophene compound, a phthalocyanine compound, a cyanine compound, a merocyanine compound, a oxonol compound, a polyamine compound, a indole compound, a pyrrol compound, a pyrazole compound, a polyarylene compound, a condensed aromatic carbocyclic compound (naphthalene derivatives, anthrathene derivatives, phenanthrene derivatives, tetracene derivatives, pyrene derivatives, perylene derivatives, fluoranthene derivatives), a metal complex having a nitrogen-containing heterocycle compound as a ligand, and the like can be used. Furthermore, as low molecular-weight materials, a porphyrin compound such as porphin, copper tetraphenylporphin, phthalocyanine, copper phthalocyanine, titanium phthalocyanine oxide; triazole derivatives, oxadiazole derivatives, imidazole derivatives, polyarylalkane derivatives, pyrazoline derivatives, pyrazolone derivatives, phenylenediamine derivatives, arylamine derivatives, amino-substituted chalcone derivatives, oxazole derivatives, styrylanthracene derivatives, fluorenone derivatives, hydrazone derivatives, silazane derivatives, and the like can be used. As polymer materials, a polymer of phenylenevinylene, fluorene, carbazole, indole, pyrene, pyrrol, picoline, thiophene, acetylene, diacetylene, and the like, and derivatives thereof can be used. It should be noted that, the donating organic compound is not limited the above-described compounds, and any organic compound having a lower ionization potential than the organic compound used as an n-type (acceptor type) compound may be used as the donating organic semiconductor, as described above.

The n-type organic semiconductor molecules are an acceptor type organic semiconductor represented mainly by an electron transporting organic compound, and indicate an organic compound having an electron accepting property (electron accepting organic material). In more detail, when two kinds of organic materials are used in contact with each other, an organic compound having a greater electron affinity is the n-type organic semiconductor molecules. Therefore, any organic compound can be used as an acceptor type organic compound, so long as the organic compound has an electron accepting property. For example, a condensed aromatic carbocyclic compound (naphthalene derivatives, anthracene derivatives, phenanthlene derivatives, tetracene derivatives, pyrene derivatives, perylene derivatives, and fluoranthene derivatives), a 5 to 7-membered heterocyclic compound containing nitrogen atom, oxygen atom, or sulfur atom (for example, pyridine, pyrazine, pyrimidine, pyridazine, triazine, quinoline, quinoxaline, quinazoline, phthalazine, cinnoline, isoquinoline, pteridine, acridine, phenazine, phenanthroline, tetrazole, pyrazole, imidazole, thiazole, oxazole, indazole, benzimidazole, benzotriazole, benzooxazole, benzothiazole, carbazole, purine, triazolopyridazine, triazolopyrimidine, tetrazaindene, oxadiazole, imidazopyridine, pyralidine, pyrrolopyridine, thiadiazolopyridine, dibenzazepine, tribanzazepine, and the like), a polyarylene compound, a fluorene compound, a cyclopentadiene compound, a silyl compound, a metal complex having a nitrogen-containing heterocyclic compound as a ligand, and the like are included. As other electron accepting organic materials, fullerene including C60 and C70 and carbon nanotube, and derivatives thereof, oxadiazole derivatives such as 1,3-bis(4-tert-butylphenyl-1,3,4-oxadiazolyl)phenylene (OXD-7), anthraquinodimethane derivatives, diphenylquinone derivatives, bathocuproin, bathophenanthroline, and derivatives thereof, a triazole compound, a tris(8-hydroxyquinolinate) aluminum complex, a bis(4-methyl-8-quinolinate) aluminum complex, distyrylarylene derivatives, a silole compound, and the like can be used, but not limited thereto.

It should be noted that, the acceptor type organic compound is not limited to the above-described compounds, and any organic compound having a greater electron affinity than the organic compound used as the donating organic compound may be used as the acceptor type organic semiconductor, as described above.

As the hole blocking layer 5 to be deposited on the photoelectric conversion layer 8, an oxide film of the material of the electrode is applied. The conduction band level of the hole blocking layer 5 has an energy level located in a deeper position than the conduction band level of the n-type semiconductor molecule contained in the photoelectric conversion layer 8, and the difference is desirably less than 0.5 eV, based on the vacuum level. Furthermore, the conduction band level of the hole blocking layer 5 has an energy level located in a deeper position by 0.3 eV or greater than the valence band level of the p-type semiconductor polymers or the p-type semiconductor molecules contained in the photoelectric conversion layer 8, based on the vacuum level, and the band gap is desirably 3.0 eV or more. Preferable examples of such material include oxides of Al, Mo, Ni, Ti, Cu, Mg, Li, Fe, and the like, but not limited thereto.

The method for forming the hole blocking layer 5 includes a technique in which after forming the counter electrode on the photoelectric conversion layer, the hole blocking layer 5 is formed through oxidation reaction by heat, light or the like in an inert gas atmosphere with a controlled oxygen concentration, or a technique for depositing an oxide of the electrode material using a technique such as coating-pyrolysis method, sol-gel method, and vapor deposition method, but not limited thereto. Usually, a natural oxide film of the electrode material formed by a natural reaction has a problem that the oxidation reaction tends to erode into the internal part of the metal. However, when an artificial metal oxide film is provided on the surface by artificially promoting the oxidation reaction, the oxidation reaction rarely erodes into the internal part. On the formation of the hole blocking layer of the present invention, the artificially-made oxide film can be formed densely and uniformly under a controlled condition before the electrode is oxidized by the natural oxidation reaction, and therefore the hole blocking layer of the present invention has the hole blocking function. As for the thickness of the hole blocking layer, since a film thickness of 20 nm or more significantly deteriorates device performance due to high insulating property, a thickness of 20 nm or less is desirable. In addition, when the oxidation reaction is carried out after forming the electrode, the oxide film can be formed in a monoatomic layer level, and therefore a film thickness of 0.1 nm or more is desirable.

In addition, as the p-type organic semiconductor and the n-type organic semiconductor, a p-type organic dye and an n-type organic dye can also be used, and preferably there are included a cyanine dye, a styryl dye, a hemicyanine dye, a merocyanine dye (including zeromethynemerocyanine (simple merocyanine)), a tri-nuclear merocyanine dye, a tetra-nuclear merocyanine dye, a rhodacyanine dye, a complex cyanine dye, a complex merocyanine dye, an allopolar dye, an oxonol dye, a hemioxonol dye, a squarium dye, a croconium dye, an azamethyne dye, a coumarin dye, an arylidene dye, an anthraquinone dye, a triphenylmethane dye, an azo dye, an azomethyne dye, a spiro compound, a metallocene dye, a fluorenone dye, a fulgide dye, a perylene dye, a phenazine dye, a phenothiazine dye, a quinone dye, an indigo dye, a diphenylmethane dye, a polyene dye, an acrydine dye, an acrydinone dye, a diphenylamine dye, a quinacridone dye, a quinophthalone dye, a phenoxazine dye, phthaloperylene dye, a porphyrine dye, a chlorophyll dye, a phthalocyanine dye, a metal complex dye, and a condensed aromatic carbocyclic type dye (naphthalene derivatives, anthracene derivatives, phenanthrene derivatives, tetracene derivatives, pyrene derivatives, perylene derivatives, and fluoranthene derivatives).

As for the method for forming these organic layers, dry film-forming methods or wet film-forming methods can be used. Specific examples of the dry film-forming methods include physical vapor deposition methods such as vacuum deposition method, sputtering method, ion plating method, MBE method, or CVD method such as plasma polymerization. As the wet film-forming methods, the coating method such as cast coating method, spin-coating method, dip-coating method, LB (Langmuir-Blodgett) method can be used. In addition, printing methods such as ink-jet printing, screen printing, or transfer methods such as thermal transfer, laser transfer may be used. Patterning may be carried out using chemical etching by photolithography and the like, physical etching by ultraviolet ray, laser, and the like, vacuum deposition or sputtering with a mask being superimposed, lift-off method, printing method, or transfer method.

The counter electrode 6 is formed on the hole blocking layer 5. As for the method for forming the counter electrode 6, the dry film-forming methods or the wet film-forming methods can be used. Specific examples of the dry film-forming methods include physical vapor deposition methods such as vacuum deposition method, sputtering method, ion plating method, MBE method, or CVD method such as plasma polymerization. As the wet film-forming methods, coating methods such as cast-coating method, spin-coating method, dip-coating method, LB (Langmuir-Blodgett) method can be used. In addition, printing methods such as ink-jet printing, screen printing, or transfer methods such as thermal transfer, laser transfer may be used. Patterning may be carried out using chemical etching by photolithography and the like, physical etching by ultraviolet ray, laser, and the like, vacuum deposition or sputtering with a mask being superimposed, lift-off method, printing method, or transfer method. As for the metal materials, a material which has a low difference in the work function from that of the hole blocking layer 5 containing the n-type semiconductor molecules and exhibits ohmic contact is desirable. Needless to say, when the counter electrode 6 is formed, caution is required not to damage the subjacent organic film (the hole blocking layer 5).

In the organic thin film solar cell formed in such way, the photoelectric conversion layer 8 (light absorbing layer) absorbs light energy, and excited electronically to generate excitons. The excitons dissociate into holes and electrons by an internal electric field formed in the vicinity of the p-n junction interface in the photoelectric conversion layer 8, or by charge separation at the interface between the photoelectric conversion layer 8 and the electron blocking layer 2 or at the interface of the photoelectric conversion layer 8 and the hole blocking layer 5. Since the holes migrate through the electron blocking layer 2 to a substrate electrode, the substrate electrode adjacent to the electron blocking layer 2 constitutes a positive electrode. Since the electrons migrate through the hole blocking layer 5 to the counter electrode, the counter electrode adjacent to the hole blocking layer 5 constitutes a negative electrode. As a result, a difference in potential is generated between the substrate electrode and the counter electrode. Such smooth migration of holes is achieved by a gradient of energy levels in HOMOs (Highest Occupied Molecular Orbitals) of the photoelectric conversion layer 8, the electron blocking layer 2 and the substrate electrode (the transparent conductor film 1). In addition, smooth migration of electrons is achieved by a gradient of energy levels in LUMO (Lowest Unoccupied Molecular Orbitals) of the photoelectric conversion layer 8, the hole blocking layer 5 and the counter electrode 6. As described above, the holes and the electrons are generated by the light absorption of the photoelectric conversion layer 8. The holes migrate through the electron blocking layer 2 to the substrate electrode according to the gradient of energy levels in the HOMOs. The electrons migrate through the hole blocking layer 5 to the counter electrode 6 according to the gradient of energy levels in the LUMOs.

### (Preparation of Example 1)

Next, Example of the present invention will be explained referring to FIG 1. As a substrate electrode, a transparent glass substrate (hereinafter, referred to as ITO substrate), on which an ITO (Indium Tin Oxide) thin film of transparent conductor film 1 is deposited, was used. The ITO substrate was subjected to ultrasonic cleaning using acetone and ethanol solutions for 10 to 15 minutes. After that, the substrate was washed with pure water or ultrapure water, and dried with nitrogen gas.

Subsequently, the ITO substrate was subjected to a hydrophilization treatment to make easy to deposit an organic semiconductor layer, by carrying out a UV-ozone treatment using a UV irradiation equipment such as an ozone cleaner to form a hydrophilic group on the surface of ITO substrate. (the surface of the ITO thin film)

On the surface of the ITO thin film which was subjected to the hydrophilization treatment, a PEDOT/PSS aqueous solution was coated by the spin-coat method to form the electron blocking layer 2. As for spin-coat conditions, the solution was spun on at an initial speed of 400 rpm for 10 seconds and final speed of 5,000 rpm for 100 seconds to deposit a film having a thickness of around 70 nm. After that, the film was subjected to thermal firing at 140°C for 10 minutes in the atmosphere under the atmospheric pressure to obtain the electron blocking layer 2.

As the photoelectric conversion layer 8, mixed materials of PCBM : P3HT were used. The weight ratio of the both materials was adjusted so as to be 1 : 0.8, and the mixture was dissolved in o-dichlorobenzene. The solution was sufficiently stirred using an ultrasonic stirrer, and then filtered through a filter having a mesh opening size of 0.45 µm, and then coated by the spin-coat method. As for spin-coat conditions, the solution was spun on at an initial speed of 400 rpm for 10 seconds and final speed of 1,500 rpm for 40 seconds to deposit a film having a thickness of around 50 nm. After that, the film was dried in vacuum at room temperature to obtain a bulk heterojunction type thin film.

Next, as for electrode formation, an aluminum thin film was formed by the vacuum deposition method. An appropriate quantity of aluminum wire was placed on a tungsten boat, and vacuum deposition was carried out to form an aluminum thin film having a thickness of 50 nm under the following conditions: degree of vacuum: high vacuum of around 2 × 10⁻⁶ Torr, deposition rate: 2 to 3 [Å/s] (0.2 to 0.3 nm/s), substrate temperature: room temperature, and substrate revolution speed: 30 rpm.

Finally, an aluminum oxide film was formed between the photoelectric conversion layer 8 and the metal electrode by carrying out a firing step at 100°C for 10 minutes in the atmosphere, to obtain the hole blocking layer 5.

The aluminum oxide film is an insulating substance having a band gap of 3 eV or more. In addition, the conduction band level of the aluminum oxide film has an energy level located in a deeper position than the conduction band level of the n-type semiconductor molecules contained in the photoelectric conversion layer 8 based on the vacuum level, and the difference is less than 0.5 eV Further, the valence band of the aluminum oxide film has an energy level located in a deeper position by 0.3 eV or more than the valence band level of the p-type semiconductor polymers or the p-type semiconductor molecules contained in the photoelectric conversion layer 8. The aluminum oxide film functions as a hole blocking layer due to these relationships.

### (Preparation of Example 2)

In Example 2, an organic thin film solar cell device was prepared, in which the thickness of the hole blocking layer 5 stacked between the photoelectric conversion layer and the counter electrode as described in Example 1 was adjusted to 20 nm. The preparation method was the same as in Example 1.

### (Preparation of Comparative Example 1)

In the structure of Example 1, an electrode was formed directly on the photoelectric conversion layer to prepare an organic thin film solar cell having a structure in which the hole blocking layer 5 had not been stacked, as illustrated in FIG 2.

### (Preparation of Comparative Example 2)

In the structure of Example 1, a dielectric substance LiF was used instead of the hole blocking layer 5 to prepare an organic thin film solar cell, as illustrated in FIG 3. Deposition of the dielectric substance was carried out by a resistance-heating vacuum deposition method, and the thickness of the LiF film was 0.5 nm.

### (Preparation of Comparative Example 3)

An organic thin film solar cell was prepared by carrying out the same procedures as in Example 1, except that the thickness of the hole blocking layer 5 stacked between the photoelectric conversion layer 8 and the counter electrode 6 was changed to 50 nm in Example 1.

### (Output characteristics of the organic thin film solar cells)

The bulk heterojunction type organic thin film solar cells of Examples 1 to 2 and Comparative Examples 1 to 3 prepared as described above were irradiated with pseudo sunlight (AM1.5) using a solar simulator to measure and evaluate output characteristics thereof, Obtained results are represented in Table 1 and Table 2.

[Table 1]

**Table 1**

| | Example 1 | Example 2 |
|---|---|---|
| Short-circuit current [mA/cm²] [mA/cm²] | 6.52 | 4. 83 |
| Open-circuit voltage [V] | 0.566 | 0.570 |
| Fill factor | 0.511 | 0.364 |
| Conversion efficiency [%] | 2.08 | 1.00 |

[Table 2]

**Table 2**

| | Comparative Example 1 | Comparative Example 2 | Comparative Example 3 |
|---|---|---|---|
| Short-circuit current [mA/cm²] | 4.31 | 5.23 | 0.403 |
| Open-circuit voltage [IV] | 0.421 | 0.537 | 0.579 |
| Fill factor | 0.357 | 0.498 | 0.152 |
| Conversion efficiency [%] | 0.647 | 1.39 | 0.0355 |

As represented in Table 1 and Table 2, in Examples 1 and 2, an effect contributing to the improvement in the photoelectric conversion efficiency was obtained due to increases in the fill factor value and the open-circuit voltage value by the hole blocking layer.

In the comparison of Example 1 and Comparative Example 1, the short-circuit current value was improved by forming the hole blocking layer 5 according to the present invention through preventing recombination on the electrode and suppressing leakage current. In addition, the fill factor was also improved by suppressing the charge recombination. Further, due to the effect of the interface of the photoelectric conversion layer and electrode as a barrier layer, the open-circuit voltage value increased and this contributed to the improvement in the efficiency.

From the comparison of Example 1 and Comparative Example 2, a difference in the effects of the hole blocking layer 5 according to the present invention and the dielectric substance LiF can be recognized. The dielectric substance LiF does not form a layer structure due to the very thin thickness of 0.5 nm and is distributed in island-like state on the photoelectric conversion layer 8. For this reason, since the dielectric substance is not a uniform film and lack of denseness, the results of Comparative Example 2 exhibited inferior values in the short-circuit current, the open-circuit voltage and the fill factor as compared with those of Example 1.

In Example 2 and Comparative Example 3, a difference in the effect by the film thickness of the hole blocking layer 5 can be recognized. In Example 2, since the film thickness of the hole blocking layer was set at 20 nm, the insulating property increased and the fill factor value decreased as compared to those of Example 1, respectively. In Comparative Example 3 in which the film thickness of the hole blocking layer was set at 50 nm, current was further suppressed and an output of the device could not be obtained. That is, such phenomena that as the film thickness increased, the fill factor became worse could be seen, and the current also became difficult to flow, and therefore it is considered that the hole blocking layer gets involved with an internal resistance of the solar cell when the thickness exceeds 20 nm.

The above description was made for Examples, but the present invention is not limited thereto. It is apparent to those skilled in the art that various modifications and alterations can be done within the spirit and the attached scope of claims of the present invention.

### DESCRIPTION OF SIGNS AND SYMBOLS

1: Transparent conductor film;
2: Electron blocking layer;
3: Hole transport layer containing p-type semiconductor polymers or p-type semiconductor molecules;
4: Electron transport layer containing n-type semiconductor molecules;
5: Hole blocking layer by an oxide film of electrode;
6: Counter electrode;
7: Insulating substance layer or dielectric substance layer;
8: Photoelectric conversion layer.

## Claims

1. An organic thin-film photoelectric-conversion device comprising a transparent conductor layer, an electron blocking layer located on said transparent conductor layer, a photoelectric conversion layer located on said electron blocking layer, a hole blocking layer located on said photoelectric conversion layer, and a counter electrode located on said hole blocking layer, said photoelectric conversion layer being composed of a layer comprising p-type semiconductor molecules or p-type semiconductor polymers and n-type semiconductor molecules in a mixed state,
wherein said hole blocking layer is a film made of a material having a band gap of 3.0 eV or more.

2. The organic thin-film photoelectric-conversion device according to claim 1, wherein said hole blocking layer is an oxide film of a material of said counter electrode.

3. The organic thin-film photoelectric-conversion device according to claim 1, wherein said hole blocking layer has a function to prevent recombination of holes and electrons in said counter electrode.

4. The organic thin-film photoelectric-conversion device according to claim 1, wherein a valence band level of said hole blocking layer has an energy level in a deeper position by 0.3 eV or more than a valence band level of the p-type semiconductor polymers or the p-type semiconductor molecules contained in said photoelectric conversion layer based on vacuum level.

5. The organic thin-film photoelectric-conversion device according to claim 1, wherein a conduction band level of said hole blocking layer has an energy level in a deeper position than a conduction band level of the n-type semiconductor molecules contained in said photoelectric conversion layer, and the difference is less than 0.5 eV

6. The organic thin-film photoelectric-conversion according to claim 1, wherein a thickness of said hole blocking layer is 0.1 nm or more and 20 nm or less.
